# EUROPEAN PATENT SPECIFICATION

(11) **EP 4 412 437 B1**
(45) Date of publication and mention of the grant of the patent: **25.11.2026**
(21) Application number: 22876282.9
(22) Date of filing: 27.09.2022
(51) Int. Cl.: H10N 15/00

(54) **THERMOELECTRIC CONVERSION ELEMENT AND SENSOR**
THERMOELEKTRISCHES WANDLERELEMENT UND SENSOR
ÉLÉMENT DE CONVERSION THERMOÉLECTRIQUE ET CAPTEUR

(30) Priority: 29.09.2021 JP 2021159974
(43) Date of publication of application: 07.08.2024
(73) Proprietor: NITTO DENKO CORPORATION, Ibaraki-shi Osaka 567-8680 (JP)
(72) Inventor: KUROSE, Manami, Ibaraki-shi, Osaka 567-8680 (JP); NAKANISHI, Yosuke, Ibaraki-shi, Osaka 567-8680 (JP); TANAKA, Hirokazu, Ibaraki-shi, Osaka 567-8680 (JP); MACHINAGA, Hironobu, Ibaraki-shi, Osaka 567-8680 (JP)
(74) Representative: Müller-Boré & Partner Patentanwälte PartG mbB
(86) International application number: PCT/JP2022/036045
(87) International publication number: WO 2023/054416

(56) References cited:
- EP-A1- 3 651 218
- WO-A1-2019/009308
- WO-A1-2020/218613
- WO-A1-2020/218613
- US-A1- 2018 331 273
- SAKAI AKITO ET AL: "Iron-based binary ferromagnets for transverse thermoelectric conversion", NATURE,, vol. 581, no. 7806, 27 April 2020 (2020-04-27), pages 53 - 57, XP037183243, DOI: 10.1038/S41586-020-2230-Z
- SAKURABA Y ET AL: "Anomalous Nernst Effect in L1 0-FePt/MnGa Thermopiles for New Thermoelectric Applications", APPLIED PHYSICS EXPRESS, vol. 6, 1 March 2013 (2013-03-01), pages 033003, XP093272244, DOI: 10.7567/APEX.6.033003

## Description

### TECHNICAL FIELD

The present invention relates to a thermoelectric conversion element and a sensor.

### BACKGROUND ART

Techniques relating to magneto-thermoelectric conversion have been known.

For instance, Patent Literature 1 describes a thermoelectric generation device utilizing an anomalous Nernst effect. The anomalous Nernst effect is a phenomenon that a voltage is generated in a direction orthogonal to both a magnetization direction and a temperature gradient when a temperature difference is caused by a heat flow through a magnetic body.

This thermoelectric generation device includes a substrate, a power generation body, and a connection body. The power generation body is formed of a plurality of thin wires disposed in parallel to each other along a surface of the substrate. Each thin wire is formed by shaping an FePt thin film formed on the substrate, and the thin wires are magnetized in the width direction. The power generation body is configured to generate electricity using a temperature difference in the direction perpendicular to the direction of magnetization due to the anomalous Nernst effect. The connection body is formed of a plurality of thin wires disposed along the surface of the substrate, parallel to and between the respective thin wires of the power generation body. Each thin wire of the connection body electrically connects one end part of each thin wire of the power generation body to an end part of another thin wire adjacent on one side to the first-described thin wire. In this way, the connection body electrically connects the respective thin wires of the power generation body in series. The connection body is, for instance, formed of Cr as a non-magnetic body.

### CITATION LIST

Patent Literature 1: JP 2014-072256 A
Non-patent Literature 1: Sakai, A. et al., Nature 2020, 581, 53-57 describes iron-based binary ferromagnets for transverse thermoelectric conversion.
Patent Literature 2: WO 2020/218613 A1 relates to a thermoelectric conversion element and a thermoelectric conversion device.
Patent Literature 3: EP 3 651 218 A1 discloses a thermoelectric conversion element and a thermoelectric conversion device.
Patent Literature 4: US 2018/0331273 A1 relates to a thermoelectric conversion device comprising a Ni-alloy wiring and a YIG body.

### SUMMARY OF INVENTION

### Technical Problem

In monitoring of physical condition in the Internet of Things (IoT) society or in thermal management in the technical field such as batteries for electric vehicle (EV) or chips for high-speed data processing, the needs for heat monitoring have been increased. For complying with such needs, use of a thermoelectric conversion element for thermal sensing may be taken into consideration.

It is understood that a thermoelectric conversion device utilizing magneto-thermoelectric conversion, such as the thermoelectric conversion device described in Patent Literature 1, can be manufactured more easily than a thermoelectric generation device utilizing the Seebeck effect. Taking these advantages into consideration, it is conceivable to use a thermoelectric conversion element utilizing magneto-thermoelectric conversion for heat sensing.

In the thermoelectric conversion device described in Patent Literature 1, the power generation body is configured to generate electricity using a temperature difference in a direction perpendicular to the direction of magnetization. On the other hand, in a thermoelectric conversion element utilizing magneto-thermoelectric conversion, it is assumed that an electromotive force is generated by a mechanism different from that of the magneto-thermoelectric conversion. For instance, in the thermoelectric conversion device described in Patent Literature 1, when a temperature gradient occurs in the length direction of thin wires of a power generation body made of FePt thin film and thin wires of a connection body made of a non-magnetic body of Cr, a thermal electromotive force due to the Seebeck effect can occur in the length direction due to the difference between the Seebeck coefficient of the FePt and the Seebeck coefficient of the Cr. Generation of the thermal electromotive force is probably not advantageous from the viewpoint of thermal sensing accuracy, because the electromotive force due to the Seebeck effect is superimposed on the electromotive force caused by the magneto-thermoelectric conversion. In addition to that, in the thermoelectric conversion device described in Patent Literature 1, a connection body formed of a plurality of thin wires is electrically connected in series to the power generation body made of a plurality of thin wires in order to increase the thermal electromotive force due to the magneto-thermoelectric effect. In such a configuration, the electromotive force due to the Seebeck effect tends to increase, which may have a significant impact on the accuracy of thermal sensing.

The magneto-thermoelectric coefficient Sₙₑ is expressed by a relational expression Sₙₑ = ρₓₓα_{xy} - Sₛₑ•σ_{xy}/σₓₓ, using an electrical resistivity ρₓₓ, a transverse magneto-thermoelectric coefficient α_{Xy}, a Seebeck coefficient Sₛₑ, and hole conductivities σ_{xy} and σₓₓ. Therefore, from the viewpoint of improving the performance of magneto-thermoelectric conversion, it is understood that a material with a large absolute value of Seebeck coefficient Sₛₑ is advantageous. Use of a material with a large Seebeck coefficient Sₛₑ may increase the magneto-thermoelectric coefficient Sₙₑ, thereby improving the thermoelectric conversion performance. Meanwhile, a material with a large Seebeck coefficient Sₛₑ tends to generate electromotive force due to a temperature difference in the in-plane direction, which tends to affect the accuracy of thermal sensing. Attempts have been made to apply Heusler alloys or the like represented by Co₂MnGa, which have a large Seebeck Sₛₑ coefficient, to magneto-thermoelectric conversion elements, but no consideration has been given to dealing with such issues.

In view of such circumstances, the present invention provides a thermoelectric conversion element that is advantageous from the viewpoint of improving the accuracy of heat sensing while utilizing the magneto-thermoelectric conversion.

### Solution to Problem

The present invention provides a thermoelectric conversion element as defined in claim 1.

### Advantageous Effects of Invention

The thermoelectric conversion element described above is advantageous from the viewpoint of improving the accuracy of heat sensing while utilizing magneto-thermoelectric conversion.

### BRIEF DESCRIPTION OF DRAWINGS

FIG. 1 is a perspective view showing an example of embodiment for a thermoelectric conversion element.
FIG. 2 is a cross-sectional view of the thermoelectric conversion element in FIG. 1, taken on a plane II as the cross section.
FIG. 3 is a cross-sectional view showing another example of thermoelectric conversion element.
FIG. 4 is a cross-sectional view showing still another example of thermoelectric conversion element.

### DESCRIPTION OF EMBODIMENTS

Hereinafter, embodiments of the present invention will be described with reference to the attached drawings. It should be noted that the present invention is not limited to the following embodiments and solely defined by the appended claims.

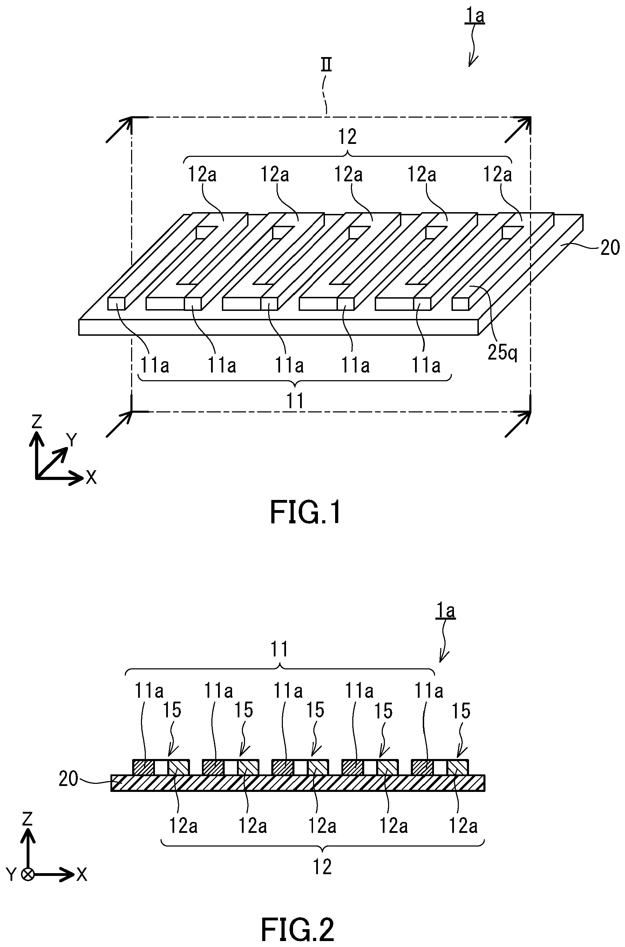

As shown in FIG. 1, a thermoelectric conversion element 1a includes a magneto-thermoelectric conversion body 11 and a wiring 12. The magneto-thermoelectric conversion body 11 extends linearly. The wiring 12 is electrically connected to the magneto-thermoelectric conversion body 11. In the thermoelectric conversion element 1a, an absolute value |ΔS| of a difference between a Seebeck coefficient Sm in a length direction of the magneto-thermoelectric conversion body 11 and a Seebeck coefficient Sc in a length direction of the wiring 12 is 10 µV/K or less. The Seebeck coefficient Sm and the Seebeck coefficient Sc are values at a temperature of 25 to 40°C, for instance, and the Seebeck coefficients can be measured according to the method described in Example. In the attached drawings, the X-axis, the Y-axis and the Z-axis are orthogonal to each other. The magneto-thermoelectric conversion body 11 and the wiring 12 are disposed along a surface parallel to the XY plane, for instance.

In the thermoelectric conversion element 1a, when a temperature gradient occurs in the length direction (Y-axis direction) of the magneto-thermoelectric conversion body 11, a thermal electromotive force due to the Seebeck effect may occur in the length direction due to the difference between the Seebeck coefficient Sm and the Seebeck coefficient Sc. However, for the thermoelectric conversion element 1a, since the absolute value |ΔS| is 10 µV/K or less, the thermal electromotive force due to the Seebeck effect that occurs in the length direction of the magneto-thermoelectric conversion body 11 tends to be smaller even if a temperature gradient occurs in the length direction. Therefore, in a sensing using the thermoelectric conversion element 1a, the electromotive force due to the Seebeck effect, which is superimposed on the electromotive force caused by the magneto-thermoelectric conversion, tends to be smaller. As a result, the thermoelectric conversion element 1a is advantageous from the viewpoint of realizing a highly accurate heat sensing by using magneto-thermoelectric conversion.

The absolute value |ΔS| may be 9.5 µV/K or less, may be 9.0 µV/K or less, may be 8.5 µV/K or less, may be 8.0 µV/K or less, may be 7.5 µV/K or less, or may be 7.0 µV/K or less. The absolute value |ΔS| may be 6.5 µV/K or less, may be 6.0 µV/K or less, may be 5.5 µV/K or less, or may be 5.0 µV/K or less. The absolute value |ΔS| may be 4.5 µV/K or less, may be 4.0 µV/K or less, may be 3.5 µV/K or less, may be 3.0 µV/K or less, may be 2.5 µV/K or less, or may be 2.0 µV/K or less. The absolute value |ΔS| may be 1.5 µV/K or less, may be 1.0 µV/K or less, may be 0.8 µV/K or less, may be 0.5 µV/K or less, may be 0.3 µV/K or less, or may be 0.2 µV/K or less. The lower limit of the absolute value |ΔS| is not limited to a specific value. The absolute value |ΔS| is 0.01 µV/K or more for instance, and it may be 0.05 µV/K or more, may be 0.1 µV/K or more, may be 0.2 µV/K or more, may be 0.5 µV/K or more, or may be 1.0 µV/K or more.

The relationship in terms of signs between the Seebeck coefficient Sm and the Seebeck coefficient Sc is not limited to a specific relationship as long as the absolute value |ΔS| is 10 µV/K or less. The Seebeck coefficient Sm and the Seebeck coefficient Sc represent values of the same sign, for instance. As a result, the absolute value |ΔS| tends to be smaller. Alternatively, the Seebeck coefficient Sm and the Seebeck coefficient Sc may represent values of different signs.

As long as the absolute value |ΔS| is 10 µV/K or less, the Seebeck coefficient Sc is not limited to a specific value. The Seebeck coefficient Sc has a value of 0 or less, for instance. The Seebeck coefficient Sc is 0 µV/K or less for instance, and it may be -5 µV/K or less, may be -10 µV/K or less, may be -15 µV/K or less, or may be -20 µV/K or less. The Seebeck coefficient Sc is -50 µV/K or more, for instance. The Seebeck coefficient Sc may be a positive value for instance, and it may be 1 µV/K or more, may be 3 µV/K or more, may be 5 µV/K or more, or may be 10 µV/K or more.

As long as the absolute value |ΔS| is 10 µV/K or less, the Seebeck coefficient Sm is not limited to a specific value. The Seebeck coefficient Sm is 0 µV/K for instance, and it may be -5 µV/K or less, may be -10 µV/K or less, may be -15 µV/K or less. The Seebeck coefficient Sm is -50 µV/K or more, for instance. The Seebeck coefficient Sm may be a positive value, for instance, it may be 1 µV/K or more, may be 3 µV/K or more, may be 5 µV/K or more, or may be 10 µV/K or more.

The absolute value |Sm| of the Seebeck coefficient Sm is desirably 10 µV/K or more. In this case, the magneto-thermoelectric coefficient tends to increase, and the thermoelectric conversion performance of thermoelectric conversion element 1a can easily be improved. The absolute value |Sm| may be 15 µV/K or more, or may be 20 µV/K or more.

As long as the absolute value |ΔS| is 10 µV/K or less, the specific resistance of the wiring 12 is not limited to a specific value. The wiring 12 has a specific resistance in a range of 8 to 200 µΩ·cm, for instance. This may facilitate adjustment of the Seebeck coefficient Sc into a desired range. Furthermore, the resistance can be lowered easily even if wiring 12 is made thinner.

The specific resistance of the wiring 12 may be 10 µΩ·cm or more, may be 15 µΩ·cm or more, may be 20 µΩ·cm or more, may be 25 µΩ·cm or more, or may be 30 µΩ·cm or more. The specific resistance of the wiring 12 may be 180 µΩ·cm or less, may be 150 µΩ·cm or less, may be 140 µΩ·cm or less, may be 130 µΩ·cm or less, may be 120 pO - cm or less, may be 110 µΩ·cm or less, or may be 100 µΩ·cm or less.

As long as the absolute value |ΔS| is 10 µV/K or less, the material for constituting the wiring 12 is not limited to a specific material. For instance, the wiring 12 includes at least one metal selected from the group consisting of Cu, Ag, Au, Al, Ni, and Co. In this case, the content of these metals in the wiring 12 is 50% or more based on the number of atoms. In other words, the content of Cu, Ag, Au, Al and Ni in the wiring 12 is 50% or more in total based on the number of atoms. This may facilitate adjustment of the Seebeck coefficient Sc to a desired value, whereby the specific resistance of the wiring 12 can be lowered easily.

The wiring 12 may be formed of a single-component metal or an alloy.

The wiring 12 may include at least one metal selected from the group consisting of Cu, Ag, Au and Al, and at least one element selected from the group consisting of a Group 8 element, a Group 9 element, and a Group 10 element. In this case, the Seebeck coefficient Sc of the alloy tends to vary over a wide range from positive to negative values depending on the composition, which may make it easy to adjust the Seebeck coefficient Sc to a desired value. The Group 8 element is Fe, for instance. The Group 9 element is Co, for instance. The Group 10 element is Ni or Pt, for instance. The content of at least one element in the wiring 12 selected from the group consisting of the Group 8 element, the Group 9 element, and the Group 10 element is not limited to a specific value. The content may be 1% or more, may be 3% or more, may be 5% or more, may be 10% or more, may be 20% or more, may be 30% or more, may be 40% or more, and is 50% or less based on the number of atoms.

As long as the absolute value |ΔS| is 10 µV/K or less, the magneto-thermoelectric conversion body 11 is not limited to a specific material. The magneto-thermoelectric conversion body 11 generates an electromotive force by means of the magneto-thermoelectric effect. The magneto-thermoelectric effect is, for instance, an anomalous Nernst effect or a spin Seebeck effect.

The magneto-thermoelectric conversion body 11 includes, for instance, a substance expressing the anomalous Nernst effect. A substance that expresses the anomalous Nernst effect is not limited to a specific substance. The substance expressing the anomalous Nernst effect is, for instance, a magnetic body having a saturation magnetic susceptibility of 5 × 10⁻³ T or more, or a substance of a band structure with a Weyl point near the Fermi energy. For instance, the magneto-thermoelectric conversion body 11 contains as a substance expressing the anomalous Nernst effect, at least one substance selected from the group consisting of (i), (ii), (iii), (iv) and (v) below.
(i) A stoichiometric substance having a composition represented by Fe₃X
(ii) An off-stoichiometric substance having a composition ratio of Fe and X that deviates from that of the substance in (i) above
(iii) A substance in which a part of the Fe site of the substance in (i) above or a part of the Fe site in the substance in (ii) above is substituted by a typical metal element or a transition element other than X
(iv) A substance having a composition represented by Fe₃M1₁₋ₓM2ₓ (0 < x < 1), where M1 and M2 are typical elements different from each other
(v) A substance in which a part of the Fe site of the substance in (i) above is substituted by a transition element other than X, and a part of the X site in the substance in (i) above is substituted by a typical metal element other than X

In the substances (i) to (v), X is a typical element or a transition element. X is, for instance, Al, Ga, Ge, Sn, Si, Ti, Zr, Hf, V, Nb, Ta, Cr, Mo, W, Sc, Ni, Mn, or Co. In the above (iv), the combination of M1 and M2 is not limited to a specific combination as long as M1 and M2 are typical elements different from each other. In the above (iv), the combination of M1 and M2 is, for instance, Ga and Al, Si and Al, or Ga and B.

The magneto-thermoelectric conversion body 11 may contain Co₂MnGa as a substance expressing the anomalous Nernst effect, or it may contain Mn₃Sn that is an antiferromagnetic body.

The magneto-thermoelectric conversion body 11 may be an alloy having a body-centered cubic lattice crystal structure, and the alloy contains Fe. In this case, a large electromotive force is likely to occur in the magneto-thermoelectric conversion body 11 due to the anomalous Nernst effect.

In a case where the magneto-thermoelectric conversion body 11 is an alloy having a body-centered cubic lattice crystal structure and the alloy contains Fe, the content of Fe and the content of the element other than Fe in the alloy are not limited to specific values. The content of Fe in the alloy is 50% or more based on the number of atoms for instance, and the content of the element other than Fe in the alloy is 10% or more based on the number of atoms, for instance. In this case, a large electromotive force is likely to be generated in the magneto-thermoelectric conversion body 11 due to the anomalous Nernst effect.

The content of Fe in the alloy may be 55% or more, may be 60% or more, may be 65% or more, or may be 70% or more based on the number of atoms. The content of Fe in the alloy may be 90% or less, may be 85% or less, or may be 80% or less based on the number of atoms.

The content of the element other than Fe may be 15% or more, or may be 20% or more based on the number of atoms. The content of the element other than Fe may be 50% or less, may be 40% or less, or may be 30% or less based on the number of atoms.

The magneto-thermoelectric coefficient S_{NE} of the magneto-thermoelectric conversion body 11 is not limited to a specific value. The absolute value of magneto-thermoelectric coefficient S_{NE} of the magneto-thermoelectric conversion body 11 is 0.5 µV/K or more, for instance. As a result, a large electromotive force may be generated easily due to the magneto-thermoelectric conversion in the magneto-thermoelectric conversion body 11, and the accuracy in sensing by means of the thermoelectric conversion element 1a can be easily improved. This may facilitate delicate heat sensing. The absolute value of the magneto-thermoelectric coefficient S_{NE} of the magneto-thermoelectric conversion body 11 is desirably 1.0 µV/K or more, more desirably 1.5 µV/K or more, and even more desirably 2.0 µV/K or more. The absolute value of the magneto-thermoelectric coefficient S_{NE} of the magneto-thermoelectric conversion body 11 may be 3.0 µV/K or more, may be 4.0 µV/K or more, may be 5.0 µV/K or more, may be 6.0 µV/K or more, may be 7.0 µV/K or more, or may be 8.0 µV/K or more.

As shown in FIGS. 1 and 2, the magneto-thermoelectric conversion body 11 includes a plurality of first thin wires 11a, for instance. And the wiring 12 includes a plurality of second thin wires 12a. In the thermoelectric conversion element 1a, the first thin wires 11a and the second thin wires 12a are electrically connected to each other in series. With this configuration, the electromotive force caused by the magneto-thermoelectric conversion occurring in the first thin wires 11a is synthesized, making it easy to obtain a large output from the thermoelectric conversion element 1a.

In the thermoelectric conversion element 1a, the first thin wires 11a and the second thin wires 12a make a plurality of thin wire pairs 15, for instance. Each thin wire pair 15 consists of a first thin wire 11a and a second thin wire 12a. In other words, each thin wire pair 15 consists of one first thin wire 11a and one second thin wire 12a. The number of thin wire pairs 15 in the thermoelectric conversion element 1a is not limited to a specific value. In the thermoelectric conversion element 1a, the first thin wires 11a and the second thin wires 12a form at least fifty thin wire pairs 15, for instance. The electromotive force due to the Seebeck effect increases as the number of pairs of dissimilar materials joined increases. Meanwhile, as for the thermoelectric conversion element 1a, the absolute value |ΔS| is 10 µV/K or less. Therefore, even if the thermoelectric conversion element 1a has fifty or more pairs of the thin wires, the thermal electromotive force tends to be smaller. Here, the thermal electromotive force due to the Seebeck effect occurs in the length direction of the magneto-thermoelectric conversion body 11 in a case where a temperature gradient occurs in the length direction.

As shown in FIGS. 1 and 2, the first thin wires 11a and the second thin wires 12a form a meander pattern. According to this configuration, even if the area of the plane on which the first thin wires 11a and the second thin wires 12a are disposed is small, a large output can be obtained easily from the thermoelectric conversion element 1a.

As shown in FIG. 1, the first thin wires 11a are disposed spaced apart from each other at predetermined intervals in the X-axis direction and parallel to each other, for instance. The first thin wires 11a are disposed at equal intervals in the X-axis direction. The second thin wires 12a electrically connect, for instance, the first thin wires 11a adjacent to each other in the X-axis direction. A second thin wire 12a electrically connects, for instance, a first end part of a first thin wire 11a in the Y-axis direction and a second end part of another first thin wire 11a adjacent to the first-described first thin wire 11a in the Y-axis direction. The first end parts in the Y-axis direction of the first thin wires 11a are positioned at the end on the same side of the first thin wires 11a in the Y-axis direction, while the second end parts in the Y-axis direction of the first thin wires 11a are positioned at the end opposite to the first end parts in the Y-axis direction of the first thin wires 11a.

The thickness of the first thin wires 11a is not limited to a specific value. The first thin wires 11a have a thickness of 1000 nm or less, for instance. Thereby, use amount of the material for the magneto-thermoelectric conversion body in the thermoelectric conversion element 1a can be decreased, and the cost for manufacturing the thermoelectric conversion element 1a can be reduced easily. In addition to that, disconnection of a conductive path formed with the first thin wires 11a and the second thin wires 12a in the thermoelectric conversion element 1a is unlikely to occur.

The thickness of the first thin wires 11a may be 750 nm or less, may be 500 nm or less, may be 400 nm or less, may be 300 nm or less, or may be 200 nm or less. The thickness of the first thin wires 11a is 5 nm or more, for instance. Thereby, the thermoelectric conversion element 1a can easily exhibit high durability. The thickness of the first thin wires 11a may be 10 nm or more, may be 20 nm or more, may be 30 nm or more, or may be 50 nm or more.

The width of first thin wires 11a, which is the dimension in the X-axis direction, is not limited to a specific value. The width of the first thin wires 11a is 500 µm or less, for instance. Thereby, use amount of the material for the magneto-thermoelectric conversion body in the thermoelectric conversion element 1a can be decreased, and the cost for manufacturing the thermoelectric conversion element 1a can be easily reduced. In addition to that, numbers of the first thin wires 11a can be easily disposed in the X-axis direction, so that the electromotive force generated in accordance with the magneto-thermoelectric conversion in thermoelectric conversion element 1a tends to be increased.

The width of the first thin wires 11a may be 400 µm or less, may be 300 µm or less, may be 200 µm or less, may be 100 µm or less, or may be 50 µm or less. The width of the first thin wires 11a is 0.1 µm or more, for instance. Thereby, disconnection of a conductive path is unlikely to occur, and the thermoelectric conversion element 1a can easily exhibit high durability. The width of the first thin wires 11a may be 0.5 µm or more, may be 1 µm or more, may be 2 µm or more, may be 5 µm or more, may be 10 µm or more, may be 20 µm or more, or may be 30 µm or more.

The thickness of the second thin wires 12a is not limited to a specific value. The thickness of the second thin wires 12a is 1000 nm, for instance. Thereby, use amount of the material for the wiring 12 can be decreased, and the cost for manufacturing the thermoelectric conversion element 1a can be reduced easily. In addition to that, disconnection of a conductive path in the thermoelectric conversion element 1a is unlikely to occur. The thickness of the second thin wires 12a may be 750 nm or less, may be 500 nm or less, may be 400 nm or less, may be 300 nm or less, may be 200 nm or less, or may be 100 nm or less.

The thickness of the second thin wires 12a is 5 nm or more, for instance. Thereby, the thermoelectric conversion element 1a can easily exhibit high durability. The thickness of the second thin wires 12a may be 10 nm or more, may be 20 nm or more, may be 30 nm or more, or may be 50 nm or more.

The width of the second thin wires 12a, which is the minimum dimension in the X-axis direction, is not limited to a specific value. The width of the second thin wires 12a is 500 µm or less, for instance. Thereby, use amount of the material for the wiring 12 in the thermoelectric conversion element 1a can be decreased, and the cost for manufacturing the thermoelectric conversion element 1a can be easily reduced. In addition to that, numbers of the second wirings 12a can be easily disposed in the X-axis direction, so that the electromotive force generated due to the magneto-thermoelectric conversion in the thermoelectric conversion element 1a tends to be increased.

The width of the second thin wires 12a may be 400 µm or less, may be 300 µm or less, may be 200 µm or less, may be 100 µm or less, or may be 50 µm or less. The width of the second thin wires 12a is 0.1 µm or more, for instance. Thereby, disconnection of the conductive path in the thermoelectric conversion element 1a is unlikely to occur, and the thermoelectric conversion element 1a can easily exhibit high durability. The width of the second thin wires 12a may be 0.5 µm or more, may be 1 µm or more, may be 2 µm or more, may be 5 µm or more, may be 10 µm or more, may be 20 µm or more, or may be 30 µm or more.

As shown in FIG. 1, the thermoelectric conversion element 1a includes further a substrate 20. The magneto-thermoelectric conversion body 11 and the wiring 12 are disposed on the substrate 20.

A material for forming the substrate 20 is not limited to a specific one. The substrate 20 does not contain MgO for instance, in its surface layer. Since the substrate 20 is not required to contain MgO in its surface layer, production of the thermoelectric conversion element 1a is less complicated, and acid resistance is also easily imparted.

The substrate 20 has flexibility, for instance, so that an object to which the thermoelectric conversion element 1a is attached can be shaped with less limitation. In a case where the substrate 20 has flexibility, the substrate 20 may include at least an organic polymer, for instance. This may make it possible to reduce the cost for manufacturing the thermoelectric conversion element 1a. Examples of the organic polymer include polyethylene terephthalate (PET), polyethylene naphthalate (PEN), acrylic resin (PMMA), polycarbonate (PC), polyimide (PI), or cycloolefin polymer (COP). The substrate 20 may be an ultrathin glass sheet. An example of ultrathin glass sheet is G-Leaf (registered trademark) manufactured by Nippon Electric Glass Co., Ltd.

An example of the method for manufacturing the thermoelectric conversion element 1a will be explained. First, on one of the principal surfaces of the substrate 20, a thin film of a precursor of the magneto-thermoelectric conversion body 11 is formed by any method such as sputtering, chemical vapor deposition (CVD), pulsed laser deposition (PLD), ion plating, or plating. Next, a photoresist is applied onto the thin film, a photomask is disposed above the thin film and exposed, followed by wet etching. As a result, a plurality of linear patterns of the precursor of the magneto-thermoelectric conversion body 11 disposed at predetermined intervals are formed. Next, on one of the principal surfaces of the substrate 20, a thin film of precursor for the wiring 12 is formed by any method such as sputtering, CVD, PLD, ion plating, or plating. Next, a photoresist is applied onto the thin film of precursor of the wiring 12, a photomask is disposed above the thin film of precursor of the wiring 12 and exposed, followed by wet etching. In this manner, the wiring 12 is obtained, and the linear patterns of the precursor of the magneto-thermoelectric conversion body 11 are electrically connected to each other. Next, the precursor of the magneto-thermoelectric conversion body 11 is magnetized to form the magneto-thermoelectric conversion body 11. A thermoelectric conversion element 1a is obtained in this way. The precursor of the wiring 12 may be magnetized to form the wiring 12, as required.

The thermoelectric conversion element 1a can be provided with a pressure-sensitive adhesive layer, for instance. In this case, the substrate 20 is disposed between the thermoelectric conversion body 11 and the pressure-sensitive adhesive layer in the thickness direction of the substrate 20. Thereby, it is possible to attach the thermoelectric conversion element 1a to an article by pressing the pressure-sensitive adhesive layer onto the article.

The pressure-sensitive adhesive layer includes, for instance, a rubber-based pressure-sensitive adhesive, an acrylic pressure-sensitive adhesive, a silicone-based pressure-sensitive adhesive, or a urethane-based pressure-sensitive adhesive. The thermoelectric conversion element 1a may be provided together with a pressure-sensitive adhesive layer and a release liner. In this case, the release liner covers the pressure-sensitive adhesive layer. Typically, the release liner is a film that can maintain the adhesiveness of the pressure-sensitive adhesive layer while covering the layer, and it can be peeled off easily from the pressure-sensitive adhesive layer. The release liner is, for instance, a film made of a polyester resin like PET. By peeling the release liner off, the pressure-sensitive adhesive layer is exposed and the thermoelectric conversion element 1a can be adhered to an article.

A sensor equipped with the thermoelectric conversion element 1a can be provided. In this sensor, for instance, when a temperature gradient occurs in the thickness direction of the substrate 20, an electromotive force is generated by the magneto-thermoelectric effect in the length direction of the magneto-thermoelectric conversion body 11. The sensor is capable of sensing heat by processing electric signals output from the thermoelectric conversion element 1a, based on the electromotive force.

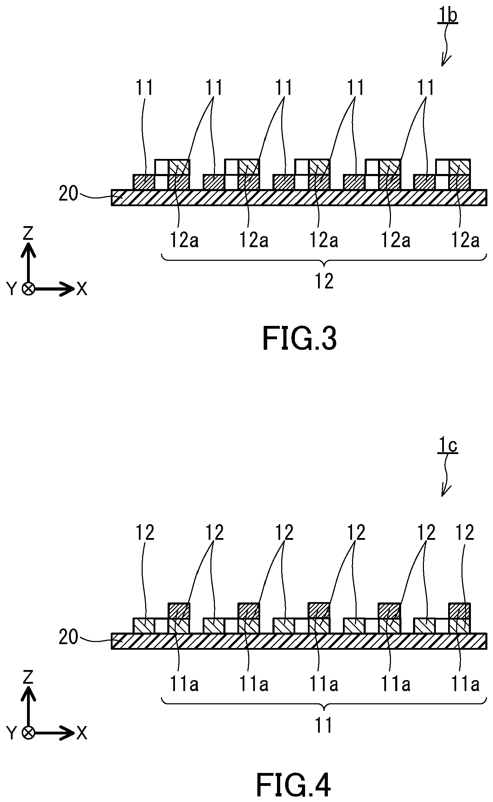

The thermoelectric conversion element 1a can be modified from various viewpoints. For instance, the thermoelectric conversion element 1a may be modified to a thermoelectric conversion element 1b as shown in FIG. 3 or a thermoelectric conversion element 1c as shown in FIG. 4. The thermoelectric conversion element 1b and the thermoelectric conversion element 1c have the same structure as the thermoelectric conversion element 1a, except for the parts that are specifically explained. Components that are the same as or correspond to those of the thermoelectric conversion element 1a are given the same reference numerals, and detailed explanations therefor are omitted. The explanations regarding the thermoelectric conversion element 1a also apply to the thermoelectric conversion element 1b and the thermoelectric conversion element 1c, unless technically contradictory.

As shown in FIG. 3, in the thermoelectric conversion element 1b, the magneto-thermoelectric conversion body 11 extends continuously on the same plane, for instance. The wiring 12 is disposed on a part of the magneto-thermoelectric conversion body 11. For instance, the second thin wires 12a are disposed spaced apart from each other at predetermined intervals on the magneto-thermoelectric conversion body 11. With such a configuration, the thermal electromotive force due to the Seebeck effect tends to be small, and furthermore, the manufacturing costs can be easily reduced.

In the thermoelectric conversion element 1b, the magneto-thermoelectric conversion body 11 forms a meander pattern, for instance. The thermoelectric conversion element 1b is configured such that a single layer of the magneto-thermoelectric conversion body 11 and a layered body including the magneto-thermoelectric conversion body 11 and the second thin wire 12a appear alternately in the X-axis direction.

As shown in FIG. 4, in the thermoelectric conversion element 1c, the wiring 12 extends continuously on the same plane, for instance. The magneto-thermoelectric conversion body 11 is disposed on a part of the wiring 12. For instance, a plurality of first thin wires 11a are disposed spaced apart from each other at predetermined intervals on the wiring 12. With this configuration, the thermal electromotive force due to the Seebeck effect tends to be small, and the manufacturing cost can be decreased easily.

In the thermoelectric conversion element 1c, the wiring 12 forms a meander pattern, for instance. The thermoelectric conversion element 1c is configured such that a single layer of the wiring 12 and a layered body including the wiring 12 and the first thin wires 11a appear alternately in the X-axis direction.

### EXAMPLES

Hereinafter, the present invention will be described in detail by referring to Examples, wherein Examples 7 and 11 are outside the scope of the present invention. It should be noted that the present invention is not limited to the following Examples. First, evaluation methods regarding Examples and Comparative Examples will be explained.

### [Measurement of Seebeck coefficient]

Using a small-sized refrigerant-free physical property measurement system PPMS VersaLab manufactured by Quantum Design, a Seebeck coefficient Sm and a Seebeck coefficient Sc in a thermoelectric conversion element according to each Example and each Comparative Example were measured, and the absolute value |ΔS| of the difference between them was determined. The Seebeck coefficient Sm is a Seebeck coefficient at 27 to 37°C in the length direction of the thin wire for magneto-thermoelectric conversion, and the Seebeck coefficient Sc is a Seebeck coefficient at 27 to 37°C in the length direction of the wiring. The results are shown in Table 1. The Seebeck coefficient Sm and the Seebeck coefficient Sc were determined based on the electromotive force and a temperature difference induced between two thermometers attached to a sample when a heat flow was generated by a heater attached to one end of the sample.

### [Measurement of magneto-thermoelectric coefficient]

The magneto-thermoelectric coefficient (Nernst coefficient) at 27 to 37°C of the thin wires for magneto-thermoelectric conversion in the thermoelectric conversion element of each Example and each Comparative Example was measured using Quantum Design's small-sized refrigerant-free physical property measurement system PPMS VersaLab. The results are shown in Table 1.

### [Measurement of thermal electromotive force of thermoelectric conversion element]

The thermoelectric conversion element according to each Example and each Comparative Example was fixed between a pair of Cu plates with dimensions of 30 mm, 30 mm, and 5 mm, using silicone grease KS609 manufactured by Shin-Etsu Chemical Co., Ltd., thereby producing a sample for thermoelectric property evaluation. This sample was placed on a cool plate SCP-125 supplied by AS ONE Corporation. A film heater manufactured by Shinwa Rules Co., Ltd. was fixed on the upper Cu plate with a double-sided tape No. 5000NS manufactured by Nitto Denko Corporation. This heater had dimensions of 30 mm square and an electrical resistance value of 20 Ω. While the temperature of the cool plate was maintained at 25°C, the film heater was made generate heat under a constant voltage control of 10 V, and the amount of heat output from the film heater was adjusted to 0.52 W/cm². At this time, the electromotive force V_{N} generated in the thermoelectric conversion element was measured using a digital multimeter so as to read the value of electromotive force in a steady state. The results are shown in Table 1.

### [Measurement of specific resistance]

Sheet resistance of the thin film for wiring was measured in each Example and each Comparative Example by the eddy current measurement method using a noncontact type resistance measuring instrument NC-80MAP manufactured by NAPSON CORPORATION in accordance with Japanese Industrial Standard (JIS) Z 2316. The specific resistance of the wiring was determined by calculating the product of the sheet resistance of the thin film for the wiring measured in this way and the thickness of the wiring. The results are shown in Table 1.

### [Measurement of electromotive force due to Seebeck effect]

In the plane of a thermoelectric conversion element according to each Example and each Comparative Example, one end in the length direction of the thin wire for thermoelectric conversion and one end in the length direction of the wiring were heated with a heater to cause a temperature difference of 1°C between the both ends of the thermoelectric conversion thin wire and the both ends of the wiring. In this state, the electromotive force Vs due to the Seebeck effect was measured. During the measurement, temperatures on both surfaces of the thermoelectric conversion element were kept constant in order to prevent a temperature gradient in the thickness direction of the thermoelectric conversion element except for one end in the length direction of the thin wire for thermoelectric conversion and wiring. The results are shown in Table 1.

### <Example 1>

A thin film having a thickness of 100 nm was formed on a polyethylene terephthalate (PET) film having a thickness of 50 µm by DC magnetron sputtering, using a target material containing Fe and Ga. In this target material, the atomic ratio of the Fe content to the Ga content was in a relationship of 3:1. A photoresist was applied onto the thin film, a photomask was disposed above the thin film and exposed, followed by wet etching. Thereby, 94 thin wires for magneto-thermoelectric conversion aligned at predetermined intervals were formed. The width of each thin wire for magneto-thermoelectric conversion was 100 µm, and the length of each thin wire for magneto-thermoelectric conversion was 15 mm. After that, a CuNi thin film having a thickness of 100 nm was formed by DC magnetron sputtering using a target material containing Cu and Ni. In this target material, the atomic ratio of the Cu content to the Ni content was in a relationship of 95:5. A photoresist was applied onto the CuNi thin film, a photomask was disposed above the CuNi thin film and exposed, followed by wet etching. Thereby, a wiring with a width of 40 µm was formed. A plurality of thin wires for magneto-thermoelectric conversion were electrically connected to each other in series by the wiring. Further, the thin wires for magneto-thermoelectric conversion and the wiring formed a meander pattern. The thin wires for magneto-thermoelectric conversion were magnetized in a direction parallel to the plane of the PET film and orthogonal to the length direction of the thin wires for magneto-thermoelectric conversion, whereby a thermoelectric conversion element according to Example 1 was obtained. This thermoelectric conversion element generated an electromotive force based on the anomalous Nernst effect.

### <Example 2>

A thermoelectric conversion element according to Example 2 was manufactured in the same manner as in Example 1 except that a wiring was formed using a target material having an atomic ratio of Cu content: Ni content = 93:7.

### <Example 3>

A thermoelectric conversion element according to Example 3 was manufactured in the same manner as in Example 1 except that a wiring was formed using a target material having an atomic ratio of Cu content: Ni content = 87:13.

### <Example 4>

A thermoelectric conversion element according to Example 4 was manufactured in the same manner as in Example 1 except that a wiring was formed using a target material having an atomic ratio of Cu content: Ni content = 79:21.

### <Example 5>

A thermoelectric conversion element according to Example 5 was manufactured in the same manner as in Example 1 except that a wiring was formed using Ni as the target material.

### <Example 6>

A thermoelectric conversion element according to Example 6 was manufactured in the same manner as in Example 1 except that a wiring was formed using a target material having an atomic ratio of Cu content: Co content = 77:23.

### <Example 7>

A thermoelectric conversion element according to Example 7, which is outside the scope of the present invention, was manufactured in the same manner as in Example 1 except that a wiring was formed using a target material having an atomic ratio of Cu content: Fe content = 41:59.

### <Example 8>

A thermoelectric conversion element according to Example 8 was manufactured in the same manner as in Example 1 except that a wiring was formed using a target material having an atomic ratio of Cu content: Ni content = 88:12.

### <Example 9>

A thermoelectric conversion element according to Example 9 was manufactured in the same manner as in Example 1 except that a wiring was formed using a target material having an atomic ratio of Cu content: Co content = 68:32.

### <Example 10>

A thermoelectric conversion element according to Example 10 was manufactured in the same manner as in Example 1 except that a wiring was formed using a target material having an atomic ratio of Cu content: Co content = 63:37.

### <Example 11>

A thermoelectric conversion element according to Example 11, which is outside the scope of the present invention, was manufactured in the same manner as in Example 1 except that a wiring was formed using a target material having an atomic ratio of Cu content: Co content = 22:78.

### <Example 12>

A thermoelectric conversion element according to Example 12 was manufactured in the same manner as in Example 1 except that a wiring was formed using a Co₂MnGa target instead of a target material containing Fe and Ga, and using a target material having an atomic ratio of Cu content: Ni content = 79:21.

### <Example 13>

A thermoelectric conversion element according to Example 13 was manufactured in the same manner as in Example 1 except that a wiring was formed using an Mn₃Sn target instead of a target material containing Fe and Ga, and using a target material having an atomic ratio of Cu content: Ag content = 50:50 .

### <Comparative Example 1>

A thermoelectric conversion element according to Comparative Example 1 was manufactured in the same manner as in Example 1 except that a wiring was formed using Cu as a target material.

### <Comparative Example 2>

A thermoelectric conversion element according to Comparative Example 2 was manufactured in the same manner as in Example 1 except that thin wires for thermoelectric conversion were formed using a target material containing Fe and Pt, and a wiring was formed using Cr as a target material. This thermoelectric conversion element generated an electromotive force based on the anomalous Nernst effect.

### <Comparative Example 3>

A thermoelectric conversion element according to Comparative Example 3 was manufactured in the same manner as in Example 1 except that a wiring was formed using Au as a target material.

### <Comparative Example 4>

A thermoelectric conversion element according to Comparative Example 4 was manufactured in the same manner as in Example 1 except that a wiring was formed using a Co₂MnGa target instead of a target material containing Fe and Ga, and using Au as a target material.

The Seebeck electromotive force Vs in the thermoelectric conversion element according to each Example was lower than the Seebeck electromotive force Vs in the thermoelectric conversion element according to each Comparative Example. The Seebeck electromotive force Vs can be reduced since the absolute value of the difference between the Seebeck coefficient Sm in the length direction of the thin wires for magneto-thermoelectric conversion and the Seebeck coefficient Sc in the length direction of the wiring is 10 µV/K or less. This is understood to be advantageous from the viewpoint of improving the accuracy of measuring the temperature difference in the thickness direction of the thermoelectric conversion element.

The present invention is defined in independent claim 1. Preferred embodiments are defined in dependent claims 2-12.

**[Table 1]**

| | Thin wires for thermoelectric conversion | | | Wiring | | |
|---|---|---|---|---|---|---|
| | Material | Seebeck coefficient Sm [µV/K] | Magneto-thermoelectric coefficient S_{NE} [µV/K] | Material | Specific resistance [µΩ·cm] | Seebeck coefficient Sc [µV/K] |
| Example 1 | Fe₃Ga | -19 | 2.0 | Cu₉₅Ni₅ | 8.2 | -11.0 |
| Example 2 | Fe₃Ga | -19 | 2.0 | Cu₉₃Ni₇ | 11.0 | -14.0 |
| Example 3 | Fe₃Ga | -19 | 2.0 | Cu₈₇Ni₁₃ | 20.0 | -19.0 |
| Example 4 | Fe₃Ga | -19 | 2.0 | Cu₇₉Ni₂₁ | 33.0 | -24.0 |
| Example 5 | Fe₃Ga | -19 | 2.0 | Ni | 18.0 | -15.0 |
| Example 6 | Fe₃Ga | -19 | 2.0 | Cu₇₇Co₂₃ | 51.0 | -16.0 |
| Example 7 | Fe₃Ga | -19 | 2.0 | Cu₄₁Fe₅₉ | 96.0 | -18.0 |
| Example 8 | Fe₃Ga | -19 | 2.0 | Cu₈₈Ni₁₂ | 18.3 | -18.7 |
| Example 9 | Fe₃Ga | -19 | 2.0 | Cu₆₈Co₃₂ | 33.4 | -18.2 |
| Example 10 | Fe₃Ga | -19 | 2.0 | Cu₆₃Co₃₇ | 32.6 | -19.0 |
| Example 11 | Fe₃Ga | -19 | 2.0 | Cu₂₂Co₇₈ | 29.7 | -19.1 |
| Example 12 | Co₂MnGa | -25 | 3.8 | Cu₇₉Ni₂₁ | 33.0 | -24.0 |
| Example 13 | Mn₃Sn | 10 | 0.5 | Cu₅₀Ag₅₀ | 7.9 | 4.5 |
| Comparative Example 1 | Fe₃Ga | -19 | 2.0 | Cu | 6.5 | 2.0 |
| Comparative Example 2 | FePt | -12 | 0.6 | Cr | 7.0 | 16.0 |
| Comparative Example 3 | Fe₃Ga | -19 | 2.0 | Au | 7.1 | 3.0 |
| Comparative Example 4 | Co₂MnGa | -25 | 3.8 | Au | 6.8 | 3.0 |

**[Table 1] (Continued)**

| | \|ΔS\| [HV/K] | Electromotive force due to Seebeck effect Vs [mV] | Thermal electromotive force V_{N} [mV] |
|---|---|---|---|
| Example 1 | 8.0 | 7.5 | 1.22 |
| Example 2 | 5.0 | 4.7 | 1.13 |
| Example 3 | 0.0 | 0 | 0.94 |
| Example 4 | 5.0 | 4.7 | 0.77 |
| Example 5 | 4.0 | 3.8 | 0.97 |
| Example 6 | 3.0 | 2.8 | 0.63 |
| Example 7 | 1.0 | 0.9 | 0.43 |
| Example 8 | 0.3 | 0.2 | 0.96 |
| Example 9 | 0.8 | 0.7 | 0.77 |
| Example 10 | 0.02 | 0.0 | 0.78 |
| Example 11 | 0.15 | 0.1 | 0.81 |
| Example 12 | 1.0 | 0.9 | 1.47 |
| Example 13 | 5.5 | 5.2 | 0.31 |
| Comparative Example 1 | 21.0 | 19.7 | 1.30 |
| Comparative Example 2 | 28.0 | 26.3 | 0.38 |
| Comparative Example 3 | 22.0 | 20.6 | 1.28 |
| Comparative Example 4 | 28.0 | 26.3 | 2.44 |

## Claims

1. A thermoelectric conversion element (1a, 1b, 1c) comprising:
a magneto-thermoelectric conversion body (11) extending linearly; and
a wiring (12) electrically connected to the magneto-thermoelectric conversion body (11),
wherein an absolute value of a difference between a Seebeck coefficient Sm in a length direction of the magneto-thermoelectric conversion body (11) at a temperature of 25 to 40°C and a Seebeck coefficient Sc in a length direction of the wiring (12) at a temperature of 25 to 40°C is 10 µV/K or less,
wherein
the wiring (12) comprises at least one metal selected from the group consisting of Cu, Ag, Au, Al, and Ni, and
a content of the metal in the wiring (12) is 50% or more based on the number of atoms.

2. The thermoelectric conversion element (1a, 1b, 1c) according to claim 1, wherein
an absolute value of the Seebeck coefficient Sm is 10 µV/K or more.

3. The thermoelectric conversion element (1a, 1b, 1c) according to claim 1, wherein
the Seebeck coefficient Sm and the Seebeck coefficient Sc represent values of the same sign.

4. The thermoelectric conversion element (1a, 1b, 1c) according to claim 1, wherein
the Seebeck coefficient Sc has a value of 0 or less.

5. The thermoelectric conversion element (1a, 1b, 1c) according to claim 1, wherein
the wiring (12) has a specific resistance in a range of 8 to 200 µΩ·cm.

6. The thermoelectric conversion element (1a, 1b, 1c) according to claim 1, wherein
the wiring (12) comprises at least one metal selected from the group consisting of Cu, Ag, Au, and Al, and at least one element selected from the group consisting of a Group 8 element, a Group 9 element, and a Group 10 element.

7. The thermoelectric conversion element (1a, 1b, 1c) according to claim 1, wherein
the magneto-thermoelectric conversion body (11) is an alloy having a body-centered cubic lattice crystal structure, the alloy containing Fe.

8. The thermoelectric conversion element (1a, 1b, 1c) according to claim 7, wherein
a content of Fe in the alloy is 50% or more based on the number of atoms, and
a content of the element other than Fe in the alloy is 10% or more based on the number of atoms.

9. The thermoelectric conversion element (1a, 1b, 1c) according to claim 1, wherein
the magneto-thermoelectric conversion body (11) has a plurality of first thin wires (11a),
the wiring (12) has a plurality of second thin wires (12a), and
the first thin wires (11a) and the second thin wires (12a) are electrically connected to each other in series.

10. The thermoelectric conversion element (1a, 1b, 1c) according to claim 9, wherein
the first thin wires (11a) and the second thin wires (12a) form fifty or more thin wire pairs (15), and
each of the fifty or more thin wire pairs (15) consists of the first thin wire (11a) and the second thin wire (12a).

11. The thermoelectric conversion element (1a, 1b, 1c) according to claim 9, wherein
the first thin wires (11a) and the second thin wires (12a) form a meander pattern.

12. A sensor comprising the thermoelectric conversion element (1a, 1b, 1c) according to any one of claims 1 to 11.

## Patentansprüche

1. Thermoelektrisches Umwandlungselement (1a, 1b, 1c), umfassend:
einen magneto-thermoelektrischen Umwandlungskörper (11), der sich linear erstreckt; und
eine Verdrahtung (12), die elektrisch mit dem magneto-thermoelektrischen Umwandlungskörper (11) verbunden ist,
wobei ein Absolutwert einer Differenz zwischen einem Seebeck-Koeffizienten Sm in einer Längsrichtung des magneto-thermoelektrischen Umwandlungskörpers (11) bei einer Temperatur von 25 bis 40°C und einem Seebeck-Koeffizienten Sc in einer Längsrichtung der Verdrahtung (12) bei einer Temperatur von 25 bis 40°C 10 µV/K oder weniger beträgt,
wobei
die Verdrahtung (12) mindestens ein Metall umfasst, ausgewählt aus der Gruppe, bestehend aus Cu, Ag, Au, Al und Ni, und
ein Gehalt des Metalls in der Verdrahtung (12) 50% oder mehr, bezogen auf die Anzahl der Atome, beträgt.

2. Thermoelektrisches Umwandlungselement (1a, 1b, 1c) nach Anspruch 1, wobei ein Absolutwert des Seebeck-Koeffizienten Sm 10 µV/K oder mehr beträgt.

3. Thermoelektrisches Umwandlungselement (1a, 1b, 1c) nach Anspruch 1, wobei der Seebeck-Koeffizient Sm und der Seebeck-Koeffizient Sc Werte desselben Vorzeichens darstellen.

4. Thermoelektrisches Umwandlungselement (1a, 1b, 1c) nach Anspruch 1, wobei der Seebeck-Koeffizient Sc einen Wert von 0 oder weniger aufweist.

5. Thermoelektrisches Umwandlungselement (1a, 1b, 1c) nach Anspruch 1, wobei die Verdrahtung (12) einen spezifischen Widerstand in einem Bereich von 8 bis 200 µΩ·cm aufweist.

6. Thermoelektrisches Umwandlungselement (1a, 1b, 1c) nach Anspruch 1, wobei die Verdrahtung (12) mindestens ein Metall, ausgewählt aus der Gruppe, bestehend aus Cu, Ag, Au und Al, und mindestens ein Element umfasst, ausgewählt aus der Gruppe, bestehend aus einem Element der Gruppe 8, einem Element der Gruppe 9 und einem Element der Gruppe 10.

7. Thermoelektrisches Umwandlungselement (1a, 1b, 1c) nach Anspruch 1, wobei der magneto-thermoelektrische Umwandlungskörper (11) eine Legierung mit einer kubisch-raumzentrierten Kristallgitterstruktur ist, wobei die Legierung Fe enthält.

8. Thermoelektrisches Umwandlungselement (1a, 1b, 1c) nach Anspruch 7, wobei ein Gehalt von Fe in der Legierung 50% oder mehr, bezogen auf die Anzahl der Atome, beträgt, und ein Gehalt des von Fe verschiedenen Elements in der Legierung 10% oder mehr, bezogen auf die Anzahl der Atome, beträgt.

9. Thermoelektrisches Umwandlungselement (1a, 1b, 1c) nach Anspruch 1, wobei der magneto-thermoelektrische Umwandlungskörper (11) eine Mehrzahl erster Dünndrähte (11a) aufweist,
die Verdrahtung (12) eine Mehrzahl zweiter Dünndrähte (12a) aufweist und
die ersten Dünndrähte (11a) und die zweiten Dünndrähte (12a) elektrisch in Reihe miteinander verbunden sind.

10. Thermoelektrisches Umwandlungselement (1a, 1b, 1c) nach Anspruch 9, wobei die ersten Dünndrähte (11a) und die zweiten Dünndrähte (12a) fünfzig oder mehr Dünndrahtpaare (15) bilden und
jedes der fünfzig oder mehr Dünndrahtpaare (15) aus dem ersten Dünndraht (11a) und dem zweiten Dünndraht (12a) besteht.

11. Thermoelektrisches Umwandlungselement (1a, 1b, 1c) nach Anspruch 9, wobei die ersten Dünndrähte (11a) und die zweiten Dünndrähte (12a) ein Mäandermuster bilden.

12. Sensor, umfassend das thermoelektrische Umwandlungselement (1a, 1b, 1c) nach einem der Ansprüche 1 bis 11.

## Revendications

1. Élément de conversion thermoélectrique (1a, 1b, 1c) comprenant :
un corps de conversion magnéto-thermoélectrique (11) s'étendant linéairement ; et
un câblage (12) connecté électriquement au corps de conversion magnéto-thermoélectrique (11),
dans lequel une valeur absolue d'une différence entre un coefficient de Seebeck Sm dans le sens de la longueur du corps de conversion magnéto-thermoélectrique (11) à une température de 25 à 40 °C et un coefficient de Seebeck Sc dans le sens de la longueur du câblage (12) à une température de 25 à 40 °C est de 10 µV/K ou moins,
dans lequel
le câblage (12) comprend au moins un métal choisi dans le groupe constitué de Cu, Ag, Au, Al et Ni, et
une teneur du métal dans le câblage (12) est de 50 % ou plus sur la base du nombre d'atomes.

2. Élément de conversion thermoélectrique (1a, 1b, 1c) selon la revendication 1, dans lequel une valeur absolue du coefficient de Seebeck Sm est de 10 µV/K ou plus.

3. Élément de conversion thermoélectrique (1a, 1b, 1c) selon la revendication 1, dans lequel le coefficient de Seebeck Sm et le coefficient de Seebeck Sc représentent des valeurs du même signe.

4. Élément de conversion thermoélectrique (1a, 1b, 1c) selon la revendication 1, dans lequel le coefficient de Seebeck Sc présente une valeur de 0 ou moins.

5. Élément de conversion thermoélectrique (1a, 1b, 1c) selon la revendication 1, dans lequel le câblage (12) présente une résistance spécifique dans une plage de 8 à 200 µΩ·cm.

6. Élément de conversion thermoélectrique (1a, 1b, 1c) selon la revendication 1, dans lequel
le câblage (12) comprend au moins un métal choisi dans le groupe constitué de Cu, Ag, Au et Al, et au moins un élément choisi dans le groupe constitué d'un élément du groupe 8, d'un élément du groupe 9 et d'un élément du groupe 10.

7. Élément de conversion thermoélectrique (1a, 1b, 1c) selon la revendication 1, dans lequel
le corps de conversion magnéto-thermoélectrique (11) est un alliage ayant une structure cristalline de réseau cubique centré, l'alliage contenant du Fe.

8. Élément de conversion thermoélectrique (1a, 1b, 1c) selon la revendication 7, dans lequel
une teneur en Fe dans l'alliage est de 50 % ou plus sur la base du nombre d'atomes, et
une teneur en l'élément autre que Fe dans l'alliage est de 10 % ou plus sur la base du nombre d'atomes.

9. Élément de conversion thermoélectrique (1a, 1b, 1c) selon la revendication 1, dans lequel
le corps de conversion magnéto-thermoélectrique (11) présente une pluralité de premiers fils fins (11a),
le câblage (12) présente une pluralité de seconds fils fins (12a), et les premiers fils fins (11a) et
les seconds fils fins (12a) sont connectés électriquement entre eux en série.

10. Élément de conversion thermoélectrique (1a, 1b, 1c) selon la revendication 9, dans lequel
les premiers fils fins (11a) et les seconds fils fins (12a) forment cinquante paires de fils fins (15) ou plus, et
chacune des cinquante paires de fils fins ou plus (15) est constituée du premier fil fin (11a) et du second fil fin (12a).

11. Élément de conversion thermoélectrique (1a, 1b, 1c) selon la revendication 9, dans lequel
les premiers fils fins (11a) et les seconds fils fins (12a) forment un motif en méandres.

12. Capteur comprenant l'élément de conversion thermoélectrique (1a, 1b, 1c) selon l'une quelconque des revendications 1 à 11.
